# DEMANDE DE BREVET EUROPEEN

(11) **EP 2 575 086 A1**
(43) Date de publication de la demande: **03.04.2013**
(21) Numéro de dépôt: 11306230.1
(22) Date de dépôt: 27.09.2011
(51) Int. Cl.: G06K 19/077

(54) **Procédé de connexion d'un microcircuit à des zones conductrices noyées dans un support**

(71) Demandeur: Gemalto SA, 92190 Meudon (FR)
(72) Inventeur: Charles, Luc, 13006 Marseille (FR); Merlin, Lionel, 13119 Saint Savournin (FR); Audouard, Laurent, 13400 Aubagne (FR)

(57) **Abrégé**

L'invention concerne un procédé de connexion de plages conductrices d'un micromodule à des zones de connexion 3a, 3b noyées dans un support d'un objet portable, comprenant les étapes suivantes de :
- placement de chaque plage conductrice en regard et à distance de chaque zone de connexion,
- connexion de chaque plage conductrice à sa zone de connexion correspondante ;

Le procédé se distingue en ce que le procédé comprend une étape de pliage d'au moins une plage conductrice en direction de sa zone de connexion correspondante.

L'invention concerne également l'objet obtenu.

## Description

### Domaine de l'invention.

L'invention concerne un procédé de connexion d'un microcircuit à des zones ou pistes conductrices noyées dans un support

Dans le domaine des cartes à puce électronique l'invention vise un procédé de connexion d'un micromodule comprenant un microcircuit, à des pistes conductrices noyées dans un corps de carte ou dans corps n insert. Les cartes à puce sont réglementées notamment par la norme ISO 7816.

L'invention peut être utilisée pour connecter des claviers, des afficheurs, des capteurs équipant notamment des cartes multi composants

L'invention peut concerner des objets portables électroniques par exemple des cartes à mémoire telles que de type SD (de la société Sandisk) ou des passeports électroniques, clés électroniques, des cartes à interface duale ou hybride (contact et sans-contact).

### Art antérieur.

Le brevet US 598 032 décrit un procédé de connexion d'un micromodule à une antenne formée dans une couche intérieure d'un corps support. L'antenne noyée dans le corps comprend des extrémités de connexion pour connecter des plages de contact du micromodule. Ces extrémités sont accessibles au fond d'au moins une cavité débouchant à la surface du corps support ; Elles sont connectées par tout moyen de raccordement aux plages de contact du micromodule. Parmi ces moyens de connexion, on trouve notamment des languettes ressorts glissées dans des puits de connexion ou de la colle conductrice remplissant ces puits.

Le brevet WO 0115504 décrit un procédé de connexion d'un micromodule de circuit intégré à une antenne noyée dans un corps de carte à puce. Le micromodule est encarté dans une cavité du corps de carte de manière à avoir les plages de contacts externes au dessus des extrémités de connexion de l'antenne ; Ensuite des percements sont effectués, notamment au laser, à travers les plages de contact conductrices et le corps de carte jusqu'aux extrémités de connexion de l'antenne. Une matière conductrice est injectée dans des percements notamment par jet d'encre pour combler ces percements et connecter l'antenne aux plages de contact affleurant de la carte à puce.

Ces procédés ont l'inconvénient de nécessiter un équipement spécifique de connexion en plus de l'équipement d'encartage et différents postes opératoires.

L'invention a pour objectif de simplifier le procédé de connexion des micromodules à des pistes ou zones de connexion conductrices enfouies dans un corps support pour notamment des raisons de coût.

### Résumé de l'invention.

Dans son principe appliqué aux cartes à puce, l'invention prévoit d'utiliser une portion repliée des plages de contact ou d'une portion conductrice de plages conductrices d'un micromodule pour connecter des surfaces de connexion enfouies dans un support.

Le repliement s'effectue de préférence dans une cavité ou évidement séparant les plages de contact (plages ou languettes ou pistes conductrices), des zones de connexion ; Le cas échéant, la connexion peut s'effecteur à travers de la matière du corps séparant les plages de contact des zones de connexion.

L'invention a donc pour objet un procédé de connexion de plages conductrices d'un micromodule à des zones de connexion 3a, 3b noyées dans un support d'un objet portable, comprenant les étapes suivantes de :
- placement de chaque plage conductrice en regard et à distance de chaque zone de connexion,
- connexion de chaque plage conductrice à sa zone de connexion correspondante ;

Le procédé se distingue en ce que le procédé comprend une étape de pliage d'au moins une plage conductrice en direction de sa zone de connexion correspondante.

Selon d'autres caractéristiques, le procédé comprend :
- Une étape de création d'un évidement dans le support pour rendre accessible chaque zone de connexion en surface du corps ;
- Une étape de comblement au moins partiel de chaque évidement pour fixer le pliage ; La matière de comblement peut être une matière conductrice effectuant un contact électrique entre lesdites portions de plage conductrice et ladite extrémité de connexion ;
- Une étape d'encartage du micromodule dans une cavité du support, ladite étape d'encartage étant accompagnée dudit pliage et dudit comblement quasi simultanés ;
- Le procédé met en oeuvre au moins une aiguille de pliage, comprenant un orifice de distribution de matière conductrice et/ou isolante en extrémité de l'aiguille.

L'invention concerne également un objet portable comprenant un support et un micromodule porté par le support, le micromodule comprenant des plages conductrices connectées à des zones de connexion noyées dans un support,
- chaque plage conductrice étant placée en regard de chaque zone de connexion et connectée à sa zone de connexion correspondante ;

L'objet se distingue en ce qu'il comprend au moins un pliage d'une plage conductrice effectué en direction d'une zone de connexion correspondante.

Brève description des figures.
- La figure 1 illustre les composants principaux d'une carte à interface duale ;
- La figure 2 illustre un micromodule comprenant un microcircuit et des plages conductrice en cours de superposition au dessus des zones de connexion d'un circuit électrique à antenne, les plages conductrices étant non repliées ;
- La figure 3 illustre le schéma de la figure précédente avec les plages conductrices reliées vers les zones de connexion du circuit et partiellement comblées.

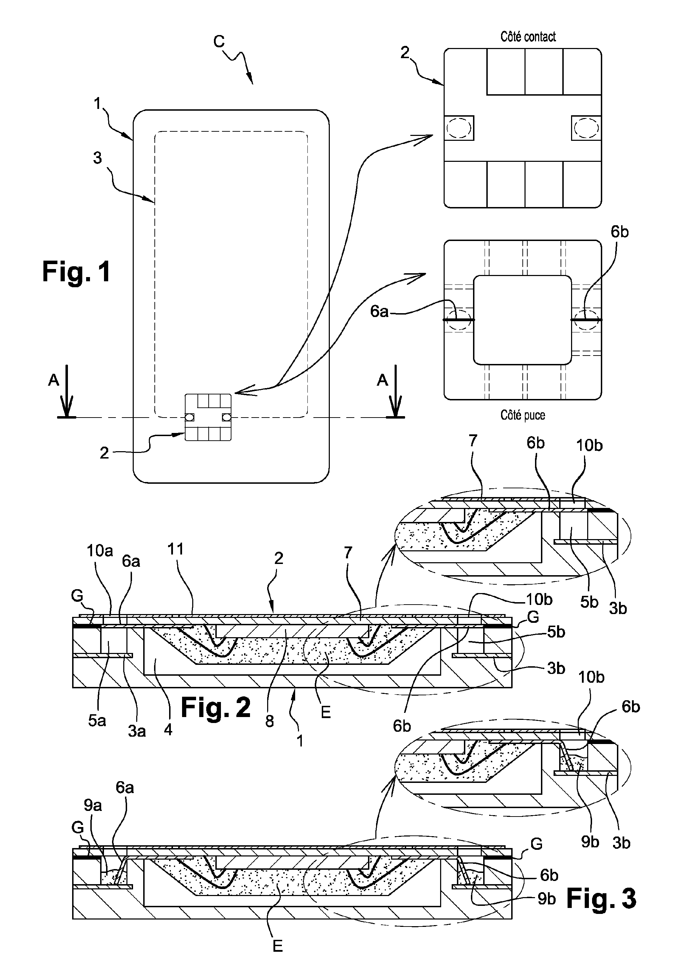

A la figure 1, une carte à puce C conforme à l'invention comprend un corps support 1 (ici un corps de carte), une antenne 3, et un micromodule 2 encarté dans une cavité 4 du corps support.

Le micromodule comprend un microcircuit intégré 8. Le micromodule est ici sensiblement conforme aux micromodules de carte à puce. Il comprend ici un enrobage E des connexions de puce aux différents contacts ou plages.

Dans l'exemple, le corps de carte comprend un ou plusieurs percement(s) ou évidement(s) 5a , 5b qui permettent un accès aux zones de connexion 3a, 3b de l'antenne 3 à partir de l'extérieur du corps. L'antenne est enfouie dans le corps de carte.

Avant la connexion, le micromodule est encarté de manière classique dans la cavité 4 du corps de carte et fixé avec, par exemple, une couche de thermofusible G , de la colle cyanoacrylate, etc. comme illustré à la figure 2.

L'objet portable peut être notamment une carte multi-composants avec notamment un afficheur et/ou un clavier et/ou un capteur. Elle peut être un passeport électronique ou une clé électronique intelligente.

Le micromodule peut comprendre des plages de contact 11 en surface ; Il comprend des plages conductrices 6a, 6b destinées à être connectées à des zones ou pistes conductrices 3a, 3b enfouies dans le support.

Selon un premier mode de réalisation (non illustré), les plages de contact peuvent comprendre les plages conductrices à connecter. Ainsi, c'est une portion de plages conductrices de surface du micromodule qui peut être repliée.

Selon un second mode de réalisation préféré et illustré sur les figures 2 et 3, les plages conductrices 6a, 6b sont réalisées ici par des languettes métalliques conductrices distinctes des plages de contact de surface du micromodule ; Ces languettes sont partiellement fixées au substrat 7 du micromodule. Le substrat porte sur une face orientée vers l'extérieur, des plages de contact 11 destinées à communiquer avec un terminal de communication externe ; Il comprend également les languettes disposées sur la face opposée destinée à être orientée vers l'intérieur de la cavité 4 du support 1.

Les languettes peuvent être formées sur le substrat isolant fin notamment par métallisation (gravure) ou collage d'une portion de feuille de métal ou de grille métallique.

Après connexion de la puce de circuit intégré notamment par fils soudés, on procède de préférence à l'enrobage de la puce, les fils et partiellement les languettes.

Les languettes 6a, 6b sont ici dans l'exemple, connectées à des plots d'une puce de circuit intégré 8 portée par le micromodule, notamment sur un substrat isolant 7. Les languettes peuvent, le cas échéant être connectées à des plages de contact de communication 11, conformes ou pas à la norme ISO 7816.

Dans la description, les mêmes références d'une figure à l'autre représentent les mêmes éléments ; Les languettes peuvent être équivalentes à des plages conductrices. Les zones ou pistes conductrices peuvent être équivalentes à des zones ou pistes de connexion.

Selon un mode de mise en oeuvre de l'invention, le procédé de connexion de plages conductrices 6a, 6b d'un microcircuit 2 à des zone de connexion 3a, 3b noyées dans un support 1, comprend les étapes suivantes de :
- placement de chaque plage conductrice 6a, 6b en regard et à distance de chaque zone de connexion « a, 3b,
- connexion de chaque plage conductrice 6a, 6b à sa zone de connexion 3a, 3b correspondante ;

Conformément à une caractéristique du mode préféré de mise en oeuvre, le procédé comprend une étape de pliage d'au moins une plage conductrice 6a, 6b en direction d'une zone de connexion correspondante.

Le pliage est réalisé de préférence juste après ou en même temps que l'opération d'encartage du micromodule dans la cavité. Toutefois, le pliage pourrait être réalisé avant l'encartage.

Le pliage concerne une portion de la languette ou plage conductrice qui est non adhérente au substrat du module. Toutefois, on pourrait prévoir une portion du substrat adhérant à la portion de plage conductrice 6a, 6b et destinée à être repliée, qui soit prédécoupée ou destinée à être découpée lors de l'encartage ou du pliage.

Le procédé peut comprendre de préférence, une étape de création d'un évidement 5a, 5b entre chaque zone de connexion 3a, 3b et chaque plage conductrice 6a, 6b.

Il n'est pas exclu d'avoir cet évidement non réalisé notamment si la matière du corps support 1 est déformable ou fin.

Le micromodule peut comprendre de préférence également un évidement de surface 10a, 10b au dessus des plages conductrices de connexion 6a, 6b. Ces évidements permettent de rendre accessibles les plages de connexion de l'extérieur du module. Ils traversent les plages de contact de surface 11 et le substrat 7 ; Les évidements de module permettent d'introduire un outil pour plier les languettes et une aiguille d'alimentation pour distribuer une colle conductrice ou isolante. L'aiguille de distribution peut être utilisée avantageusement pour plier les plages conductrices.

Le procédé peut donc mettre en oeuvre au moins une aiguille de pliage avec un orifice de distribution de matière conductrice ou isolante en extrémité de l'aiguille.

Le procédé peut comprendre une étape d'encartage du micromodule dans une cavité du support, l'étape d'encartage étant accompagnée du pliage et du comblement de l'évidement quasi simultanément ou du moins sur le même poste opératoire.

Après le pliage et encartage, le procédé peut comprendre une étape de comblement au moins partiel de chaque évidement pour fixer le pliage. Suite au pliage et mise en place du micromodule dans la cavité, la languette peut être ou non en contact avec les zones de connexion.

De préférence, la matière de comblement est une matière ou colle conductrice effectuant un contact électrique entre lesdites portions de surface métallique et ladite extrémité de connexion.

Pour réaliser la connexion, selon le mode préféré de mise en oeuvre, on effectue le pliage de la portion non fixée de la languette et une soudure est effectuée avec de la colle conductrice 9a, 9b.

La matière de comblement des évidements 5a, 6a, 5b, 6b peut être recouverte par une matière isolante affleurant en surface du micromodule. Le cas échéant on assure avec la mêmes matière une connexion entre une zone 3b, une plage conductrice 6b et une plage de contact de surface 11.

Le micromodule de l'invention peut être remplacé par un autre composant électronique ou électrique tel qu'un afficheur, un interrupteur, un clavier, etc.

## Revendications

1. Procédé de connexion de plages conductrices (6a, 6b) d'un micromodule (2) à des zones de connexion 3a, 3b noyées dans un support (1) d'un objet portable (C), comprenant les étapes suivantes de :
- placement de chaque plage conductrice (6a, 6b) en regard et à distance de chaque zone de connexion (3a, 3b),
- connexion de chaque plage conductrice (6a, 6b) à sa zone de connexion correspondante (3a, 3b),
**caractérisé en ce que** le procédé comprend une étape de pliage d'au moins une plage conductrice (6a, 6b) en direction de sa zone de connexion correspondante (3a, 3b).

2. Procédé de communication radiofréquence selon la revendication précédente, **caractérisé en ce qu'**il comprend une étape de création d'un évidement (5a, 5b) dans le support pour rendre accessible chaque zone de connexion (3a, 3b) en surface du corps.

3. Procédé de communication radiofréquence selon la revendication précédente, **caractérisé en ce qu'**il comprend une étape de comblement au moins partiel de chaque évidement (5a, 5b) pour fixer le pliage.

4. Procédé selon la revendication précédente, **caractérisé en ce que** la matière de comblement est une matière conductrice effectuant un contact électrique entre lesdites plages conductrices (6a, 6b) et ladite zone de connexion correspondante (3a, 3b).

5. Procédé selon l'une quelconque des revendications 3 ou 4, **caractérisé en ce qu'**il comprend une étape d'encartage du micromodule (2) dans une cavité (4) du support, ladite étape d'encartage étant accompagnée dudit pliage et dudit comblement quasi simultanément.

6. Procédé selon l'une quelconque des revendications précédentes, **caractérisé en ce qu'**il met en oeuvre au moins une aiguille de pliage, comprenant un orifice de distribution de matière conductrice en extrémité de l'aiguille pour plier la plage conductrice et distribuer de la matière.

7. Objet portable comprenant un support (1) et un micromodule (2) porté par le support, le micromodule comprenant des plages conductrices (6a, 6b) connectées à des zones de connexion (3a, 3b) noyées dans un support (1),
- chaque plage conductrice (6a, 6b) étant placée en regard de chaque zone de connexion (3a, 3b) et connectée à sa zone de connexion correspondante (3a, 3b), **caractérisé en ce qu'**il comprend au moins un pliage d'une plage conductrice (6a, 6b) effectué en direction d'une zone de connexion correspondante (3a, 3b).
